# EUROPEAN PATENT APPLICATION

(11) **EP 3 285 295 A1**
(43) Date of publication of application: **21.02.2018**
(21) Application number: 17162016.4
(22) Date of filing: 21.03.2017
(51) Int. Cl.: H01L 23/495

(54) **A METHOD FOR MANUFACTURING SEMICONDUCTOR DEVICES, AND CORRESPONDING DEVICE**

(30) Priority: 19.08.2016 IT 201600086321
(71) Applicant: STMicroelectronics S.r.l., 20864 Agrate Brianza (MB) (IT)
(72) Inventor: CREMA, Paolo, I-20871 Vimercate (Monza Brianza) (IT); CASATI, Paolo, I-20099 Sesto San Giovanni (Milano) (IT)
(74) Representative: Bosotti, Luciano

(57) **Abstract**

Semiconductor devices (10) comprising at least one electrically conductive metal element (16) in a nonconductive package material (20) are manufactured by:
- providing a first metal layer (102) having a smooth morphology for covering the aforesaid metal element (16); and
- providing a second metal layer (104) for covering partially the first layer (102), leaving at least one portion of the surface of the first layer (102) exposed, the second layer (104) having a rough morphology.

There may moreover be provided a die pad (14) for mounting a semiconductor die (12) by providing the aforesaid first layer (102) for covering the die pad (14) and attaching a semiconductor die (12) on the die pad (14) in contact with said first layer (102).

## Description

### Technical field

The present disclosure relates to the manufacture of semiconductor devices such as integrated circuits.

One or more embodiments may apply to the formation of electrically conductive contacts, for example copper contacts, in such devices.

### Technological background

The market of semiconductor circuits, in particular integrated circuits, imposes on manufacturers increasingly stringent requirements, for example in sectors such as the automotive sector.

For instance, there is felt the need to provide packages of semiconductor circuits based upon the use of so-called metal lead frames (LF) that are able to withstand thermomechanical stresses, such as the ones induced by assembly processes or by repeated activation/deactivation (on/off) cycles.

For instance, it is desirable to achieve a good level of intrinsic robustness in regard to phenomena such as delamination so as to be able to arrive at solutions that can be defined as delamination-free, namely with a package structure that is able to withstand phenomena of delamination between different materials such as, for example, the electrically conductive material (copper) of the lead frame and the resin or compound of the package.

Documents such as US 2009/0315159 A1 are representative of the known art.

### Object and summary

The object of one or more embodiments is to contribute to tackling the problems outlined previously.

According to one or more embodiments, the above object can be achieved thanks to a method presenting the characteristics recalled in the ensuing claims.

One or more embodiments may also regard a corresponding semiconductor device.

The claims form an integral part of the description of examples of embodiment provided herein.

One or more embodiments may envisage resorting to a material (e.g., copper) of a rough type that is able to improve adhesion to the resin/compound of the package so that the overall structure will be practically insensitive to phenomena of delamination (e.g., between the copper material and the resin) that might be induced by thermal cycles that are set up, for example, following upon switching-on and switching-off of the device during its service life.

In one or more embodiments, adhesion between the two different materials may be due to mechanisms of a mechanical and chemical nature, i.e., to the presence of asperities (peaks or troughs) to which the resin can adhere and to the increase in the contact surface that is such as to enable a higher chemical interaction per unit surface.

One or more embodiments may be based upon the observation of the fact that, as compared to a surface made, for example, of copper of a standard type, by resorting to a rough version it is possible to obtain an increase in the effective surface, for example, in the region of 100-150%.

A rough surface may, on the other hand, lead to onset of undesired phenomena such as a modification in the characteristics of wettability, with increase of the effect known as "epoxy bleed-out" (EBO).

One or more embodiments may consequently envisage providing a stack of two layers of material, for example, two copper layers, the first layer being made of copper of the bright (brite) type, for example electroplated over the entire surface of the lead frame, for instance for a minimum thickness of 1 µm, which is such as to enable also a stable attachment, for example, of the semiconductor die, and the second layer being made of rough copper, formed, for example, by electroplating also in this case for a minimum thickness of approximately 1 µm over dedicated areas of the lead frame, for example to enable a stable connection of the wire-bonding type, using for example copper wires.

One or more embodiments may be based upon the realization of the fact that the techniques that envisage a spot deposition of silver (e.g., of a semi-bright type) may not offer a sufficient degree of adhesion for the resin/compound of the package. Deposition of the layers is, moreover, problematical and the deposited layers have a rough morphology, which may give rise to delamination between the silver and the resin, with the bonding wires (e.g., copper wires) that are susceptible to failure in the presence of thermal cycles.

### Brief description of the drawings

One or more embodiments will now be described, purely by way of non-limiting example, with reference to the annexed drawings, wherein:
- Figure 1 is a schematic cross-sectional view of a semiconductor device;
- Figure 2 is a view approximately corresponding to the arrow II of Figure 1, which illustrates characteristics of embodiments; and
- Figure 3 is a synthetic representation of modalities of production of embodiments.

It will be appreciated that, for clarity and simplicity of illustration, the various figures and the parts visible therein may not be represented all at the same scale.

### Detailed description

In the ensuing description, various specific details are illustrated, in order to provide an in-depth understanding of various examples of embodiments. The embodiments may be obtained without one or more of the specific details, or with other methods, components, materials, etc. In other cases, known structures, materials, or operations are not illustrated or described in detail so that the various aspects of the embodiments will not be obscured.

Reference to "an embodiment" or "one embodiment" in the framework of the present description is intended to indicate that a particular configuration, structure, or characteristic described in relation to the embodiment is comprised in at least one embodiment. Consequently, phrases such as "in an embodiment", "in one embodiment", and the like that may be present in various points of the present description do not necessarily refer exactly to one and the same embodiment. Moreover, particular conformations, structures, or characteristics may be combined in any adequate way in one or more embodiments.

The references used herein are provided simply for convenience and hence do not define the sphere of protection or the scope of the embodiments.

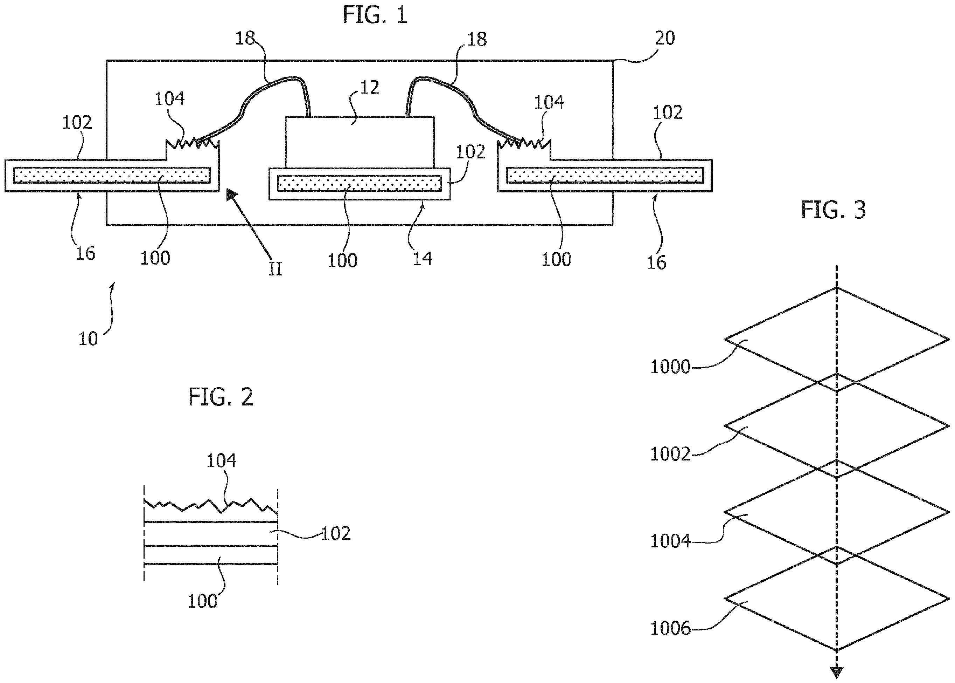

Figure 1 is a schematic illustration of a semiconductor device 10, such as an integrated circuit.

In one or more embodiments, the device 10 may comprise a semiconductor chip or die (constituting the integrated circuit proper) 12 mounted on a so-called die pad 14 that can be connected to the outside through electrically conductive contacts (lead tips) 16, it being possible to arrange the ensemble in a so-called "lead frame" (LF), to which there may be bonded electrical wires 18 to constitute a so-called wire-bonding configuration, which extends between the lead frame (lead tip) 16 and electrical contact pads, or bonding pads, (not visible in the figures) provided on the surface of the die 12.

The ensemble of parts described can then be located in a casing or package 20 comprising a resin or compound that is such as to enable moulding of the package of the device 10.

What has been described schematically above corresponds to solutions known in the art, which renders a more detailed description herein superfluous.

As already discussed previously, one or more embodiments tackle the problem of possible delamination phenomena that may arise, for example, between the structures made of metal material (e.g., copper) of the leads 16 and the resin of the package 20.

One or more embodiments tackle the above aspect by improving adhesion between the aforesaid materials, this being obtained by increasing interpenetration of the above materials (mechanical approach) and by creating bonds that are able to form bridges between the two materials (chemical approach).

In one or more embodiments, to increase interpenetration between the materials, it is possible to roughen the surface of the metal material (e.g., copper) in such a way that, when the material of the package (resin) 20 is, for example, spread on the lead frame comprising the leads 16, this material can encounter a greater number of bonding sites.

In one or more embodiments, it is possible to envisage growth of a number of layers of metal material.

In what follows, one or more embodiments will be exemplified with reference, as metal material, to copper, envisaging that the growth of layers of material is applied to the lead frame, for instance, to the leads 16, with particular attention paid, for example, to the sites for bonding the wires 18.

The above is provided merely by way of example and hence is not to be understood as in any way limiting the scope of the embodiments, for example as regards the choice of the metal material.

For instance, in one or more embodiments, the copper may be replaced by silver or nickel.

For instance, in one or more embodiments, it is possible to envisage that on the base layer, made, for example, of copper, and designated by 100 (in practice, the copper material that would otherwise constitute the base structure both of the die pad 14 and of the leads 16 of the lead frame), there will be formed, for instance, with the growth techniques exemplified in what follows:
- a first layer 102 with a smooth morphology (e.g., of the type defined, in the case of copper, as bright (brite) copper); and
- a second (localised) layer 104 with a rough morphology.

In one or more embodiments (see, for example, Figure 2, for simplicity of representation) the first flat layer 102 may comprise copper that is deposited, on the base raw-copper structure 100, for example electrolytically with a fine-grain structure, for example with a thickness of 1 to 2 µm and a roughness (rugosity), expressed as surface ratio (SR), i.e., the ratio *fᵣ=Aᵣ*/*A_{g}* between the real or effective surface area *Aᵣ* and the geometrical surface area *A_{g},* of approximately 1.

The second layer 104 (which is also, in one or more embodiments, electrodeposited) may have a granular (nodular) structure with a surface roughness SR (once again defined as surface ratio, i.e., as the ratio *Aᵣ*/*A_{g}*) comprised, for example, in the range between 1.2 and 3.0 with a thickness of, for example, between 1 and 3 µm.

Of course, reference to electrolytic deposition is not to be understood as in any way limiting the embodiments.

In one or more embodiments, it is in fact possible to resort, both for the layer 102 and for the layer 104, to the use of other methods such as chemical-vapour deposition (CVD), sputtering, electroless plating, spray-coating, etc.

In one or more embodiments (see, for example, Figure 1), the first layer 102 (i.e., the smooth layer) can be deposited over the entire surface of the base structure 100, i.e., over the surface of the lead frames, as well as, optionally, over the surface of the die pad 14.

In one or more embodiments, the second layer 104 (i.e., the rough layer) may, instead, be deposited selectively (e.g., using a mechanical mask or some other masking technique) so as to extend selectively only over certain areas, such as those of the leads 16.

Such selective deposition can be carried out either on one side or on both sides of the lead frame, with selective deposition on one or more areas of interest.

For instance, Figure 1 refers to the possibility of depositing the rough layer 104 at the "proximal" tips of the leads 16 of the lead frame, where bonding of the wires 18 may be carried out.

In one or more embodiments, the area of interest on which (also) the rough layer 104 is deposited may involve other areas of the leads 16 and/or areas of the die pad 14, for example, with a morphology of deposition of a ring type in the case of the lead frame 16 and a localised deposition, for example in the case of the die pad 14.

One or more embodiments as exemplified may afford advantages of various nature.

For instance, in one or more embodiments, it is possible to perform a die attach (DA) of the chip or die 12 on the copper die pad 14, without running the risk of giving rise to creeping effects.

In particular, in one or more embodiments, it is possible to avoid resorting, for attaching the die 12 to the die pad 14, to die-attach (DA) techniques using high-melting-point alloys, for example alloys with a lead (Pb) base, which can give rise to creeping phenomena, with migration of the molten lead beyond the area of the die pad, with consequent possible need to reject the device.

In one or more embodiments, it is possible to carry out a die attach adhesively, without giving rise to appreciable risks of triggering EBO phenomena. In particular, in the case of die attach of an adhesive type, for example with epoxy glues, it is possible to prevent onset of phenomena of bleed-out of the solvents, which are likely to induce delamination, a phenomenon that may arise in a particularly accentuated form on very rough surfaces.

One or more embodiments may then facilitate wire bonding of the wires 18 (e.g., copper wires) to the leads 16. In one or more embodiments, soldering of the bonding wires 18 to the leads of the lead frame 16 can be carried out without any appreciable risks of giving rise to the phenomenon known as "outer lead-tip de-wetting", i.e., the phenomenon that may arise mainly in the case of pre-plated lead frames with high roughness that is to be reduced through rather severe pretreatments prior to soldering, with the corresponding need to increase the thickness of the soldering mass to enhance levelling of the asperities.

In addition, the rough area 104 is able to improve adhesion to the compound (resin) of the package 20, so reducing (and virtually eliminating) any risks of delamination.

In one or more embodiments, a multilayered structure 102, 104, as exemplified in the figures, affords a solution to various problems that are liable to emerge in the case where just a structure of a rough type were to be used, for example considering that the increased roughness may at times favour undesired phenomena of capillarity.

It is likewise possible to prevent phenomena that are linked to the high roughness of copper as a whole and are likely to increase adhesion to the resin of the package 20, which, however, is unfavourable to removal of the so-called runners that are to be removed.

Similar considerations apply also to deflashing, i.e., the mechanism linked to the fact that the residue of flash are difficult to remove especially on slugs of power packages.

One or more embodiments avoid these drawbacks thanks to the possibility of providing roughness only in the areas where this is actually required (e.g., the tips where bonding of the wires 18 is carried out). It is thus possible to achieve an ideal synthesis between the increase of adhesion and prevention of delamination and of the drawbacks outlined previously.

The possible recourse, for the layer 102, to smooth (bright) copper likewise enables various advantages linked to its intrinsic purity to be achieved.

For instance, it facilitates die-attach bonding of the die 12 to the die pad 14 using a soft-solder die-attach (SSDA) technique, with the possibility of operating with a wider operating window.

As regards the wire-bonding operation, one or more embodiments may enable bonding with copper wire 18, also in this case with wider operating windows thanks to the greater ductility and lower hardness as compared to the copper of the base structure.

Furthermore, since the layer 102 is, for example, an electrodeposited layer, it is possible to attain a good level of absence of defects and porosities.

One or more embodiments may comprise the operating steps represented schematically in the diagram of Figure 3.

After an initial degreasing step 1000, it is possible to proceed to an activation step 1002 followed by deposition (in a step 1004) of the layer 102, for instance of bright copper (with a thickness of, for example, 2 µm), and then - in a step 1006 - to deposition (e.g., spot deposition) of the rough copper 104 (also here, for example, with a thickness of around 2 µm).

In practice, processes such as electrodeposition processes are well-suited for application of copper layers either in full mode, i.e., over the entire surface (e.g., the layer 102) or selectively (e.g., the rough layer 104). Chemical-deposition technologies likewise constitute technically valid solutions.

With current techniques, plating of the lead frames may be carried out using machines of the reel-to-reel (R2R) type, along with mechanical masks that are able to produce localised deposits (spots) of silver.

This technology may be adapted, with minor variations at a system level, to a localised deposition of the rough material 104.

One or more embodiments may consequently envisage a method for manufacturing semiconductor devices (e.g., 10) comprising at least one electrically conductive metal element (e.g., the leads 16 of the lead frame) in a non-conductive package material (e.g., 20), the method comprising:
- providing a first metal layer (e.g., 102), which covers said at least one metal element, said first layer having a smooth (flat) morphology; and
- providing a second metal layer (e.g., 104), which in part covers said first layer, leaving at least one portion of the surface of the first layer exposed, said second layer having a rough morphology.

One or more embodiments may comprise bonding, preferably by soldering, electrically conductive wires (e.g., 18) to said second layer.

In one or more embodiments:
- said first layer may have a thickness of 1-2 µm; and/or
- said second layer may have a thickness of 1-3 µm.

In one or more embodiments:
- said first layer may have a roughness (rugosity) with a surface ratio (SR) of approximately 1; and/or
- said second layer may have a roughness with a surface ratio (SR) of 1.2 to 3.0.

In one or more embodiments, at least one, and preferably all, from among said metal element, said first layer, and said second layer may comprise copper.

In one or more embodiments said first layer may comprise bright (brite) copper.

One or more embodiments may comprise obtaining said first layer and said second layer using one of the following techniques: electrolytic deposition, chemical-vapour deposition, sputtering, electroless plating, and spray-coating.

In one or more embodiments, said metal element may comprise at least one contact lead (e.g., 16) provided with a lead tip, where the method comprises providing said second layer (e.g., only) on said tip.

One or more embodiments may comprise providing a die pad (e.g., 14) for mounting a semiconductor die (e.g., 12) in said package, and the method may comprise:
- providing said first layer for covering said die pad; and
- attaching a semiconductor die on said first layer on said die pad.

One or more embodiments may regard a semiconductor device comprising:
- at least one electrically conductive metal element in a non-conductive package material;
- a first metal layer for covering said metal element, said first layer having a smooth (flat) morphology; and
- a second metal layer for covering partially said first layer, leaving at least one portion of the surface of said first layer (102) exposed, said second layer having a rough morphology.

One or more embodiments may comprise:
- a die pad (e.g., 14) for mounting a semiconductor die in said package;
- said first layer for covering said die pad; and
- a semiconductor die attached on said die pad on said first layer.

In one or more embodiments, said metal element may comprise at least one lead provided with a tip, with said second layer (104) provided (e.g., only) on said tip.

Without prejudice to the underlying principles, the details of construction and the embodiments may vary, even significantly, with respect to what has been illustrated herein purely by way of non-limiting example, without thereby departing from the sphere of protection, this sphere of protection being defined by the annexed claims.

## Claims

1. A method of manufacturing semiconductor devices (10) including at least one electrically-conductive metal member (16) in a non-conductive package material (20), the method including:
- providing a first metal layer (102) covering said electrically-conductive metal member (16), said first layer (102) including a flat morphology, and
- providing a second metal layer (104) covering partly said first layer (102) by leaving at least one surface portion of said first layer (102) uncovered, said second layer (104) including a rough morphology.

2. The method of claim 1, including bonding, preferably by soldering, electrically-conductive wires (18) to said second layer (104).

3. The method of claim 1 or claim 2, wherein:
- said first layer (102) has a thickness of 1-2 micron (1-2.10⁻⁶ m), and/or
- said second layer (104) has a thickness of 1-3 micron (1-3.10⁻⁶ m).

4. The method of any of claims 1 to 3, wherein:
- said first layer (102) has rugosity surface ratio or SR of about 1, and/or
- said second layer (104) has a rugosity surface ratio or SR rugosity of 1,2 to 3,0.

5. The method of any of the previous claims wherein at least one, and preferably all of said metal member (16), said first layer (102) and said second layer (104) include copper.

6. The method of any of the previous claims, wherein said first layer (102) includes brite copper.

7. The method of any of the previous claims, including providing said first layer (102) and said second layer (104) by one of electrolytic deposition, chemical vapour deposition, sputtering, electroless plating and spray coating.

8. The method of any of the previous claims, wherein said metal member includes at least one contact lead (16) having a lead tip, wherein the method includes providing said second layer (104) at said tip.

9. The method of any of the previous claims, including providing a die pad (14) for mounting a semiconductor die (12) in said package (20), the method including:
- providing said first layer (102) covering said die pad (14), and
- attaching a semiconductor die (12) on said die pad (14) at said first layer (102).

10. A semiconductor device (10), including:
- at least one electrically-conductive metal member (16) in a non-conductive package material (20),
- a first metal layer covering said at least one metal member (16), said first layer (102) having a flat morphology, and
- a second metal layer covering partly said first layer (102) by leaving at least one surface portion of said first layer (102) uncovered, said second layer (104) having a rough morphology.

11. The semiconductor device (10) of claim 10, including:
- a die pad (14) for mounting a semiconductor die (12) in said package (20),
- said first layer (102) covering said die pad (14), and
- a semiconductor die (12) attached on said die pad (14) at said first layer (102).

12. The semiconductor device (10) of claim 10 or claim 11, wherein said metal member includes at least one contact lead (16) having a lead tip, with said second layer (104) provided at said tip.
